Europäisches Patentamt

European Patent Office

Office européen des brevets

(11) Publication number: **0 176 165**

**A2**

# EUROPEAN PATENT APPLICATION

(21) Application number: **85302894.2**

(22) Date of filing: **25.04.85**

(51) Int. Cl.⁴: **G 01 R 19/165**

(30) Priority: **23.05.84 GB 8413227**

(43) Date of publication of application:
**02.04.86 Bulletin 86/14**

(84) Designated Contracting States:
**AT BE CH DE FR IT LI LU NL SE**

(71) Applicant: **STANDARD TELEPHONES AND CABLES PUBLIC LIMITED COMPANY**
**190 Strand**
**London, WC2R 1DU(GB)**

(72) Inventor: **Rokos, George Hedley Storm**
**16, South Road**
**Bishops Stortford Hertfordshire(GB)**

(74) Representative: **Capsey, Sydney Ross**
**Standard Telephones and Cables Patent Department**
**Edinburgh Way**
**Harlow Essex CM20 2SH(GB)**

(54) **Voltage difference detector.**

(57) A voltage difference detector with a pair of current mirrors each formed by a first, diode connected, transistor ($T_7$, $T_{10}$) and a second transistor ($T_8$, $T_{11}$) with matched resistors ($R,R^1$) in their collector circuits. A reference voltage ($V_{REF}$) is applied to the commoned emitter of two level sensing transistors ($T_9$, $T_{12}$) whose bases are respectively strapped to the collectors of the second transistors ($T_8$, $T_{11}$) of the current mirrors.

Croydon Printing Company Ltd.

EP 0 176 165 A2

G.H.S. Rokos 0176165
EPC and JAPAN

## VOLTAGE DIFFERENCE DETECTOR

This invention relates to voltage difference detectors. Such detectors are used for instance in cable communications, computer bus systems and fault detectors. The invention is particularly concerned with difference detectors that are suitable for use with balanced systems, such as a differential line receiver, or as a symmetrical 'window' detector, although its use is not confined to such applications. Such a differential line receiver may for instance form part of a data bus transceiver.

According to the present invention there is provided a voltage difference detector having first and second signal voltage inputs connected by matching resistors to the collectors of two grounded emitter transistors of a current mirror constructed such that in operation the current in the collector circuit of the first transistor is matched by that of the second, characterised in that the collector of the second transistor is strapped to the base of a matching third transistor whose emitter provides a reference voltage input.

The present invention also provides a voltage difference detector including a pair of current mirrors constructed such that in operation the collector current of a first transistor of each current mirror is matched by an equal collector current in a second transistor of that current mirror, characterised in that the collectors of the second transistors of the two current mirrors are respectively strapped to the two bases of two level sensing transistors providing a reference voltage input for the difference detector at their commoned emitters, and wherein the collector circuits of the first and second transistors of each current mirror are provided with a matching pair of resistors which are cross coupled with those of the other current mirror so as to provide first and second signal voltage inputs for the difference detector, with the first signal input connected via one of the resistors with the collector of the first transistor of one of the current mirrors and via another of the resistors with the collector of the second transistor of the other of the current mirrors, and with the second signal input connected respectively with the other two collectors of the transistors of the current mirrors via the other two of the resistors.

A preferred embodiment of the invention will now be described in relation to prior art difference detectors. The description refers to the accompanying drawings in which :

Figure 1 is a circuit diagram of a prior art difference detector which employs operational amplifiers to eliminate any common mode voltage,

Figure 2 is a circuit diagram of an alternative difference detector, also of the prior art, in which the voltage level of in the input signals are shifted by fixed amounts, before they are fed to a comparator,

Figure 3 is a circuit diagram of a further alternative difference detector of the prior art which employs a current mirror technique for balanced difference detection.

Figure 4A and 4B are circuit diagrams of difference detectors according to the present invention, and

Figures 5 and 6 are circuit diagrams of alternative forms of level shifting and buffering which may be included prior to the circuit of Figure 4A or 4B.

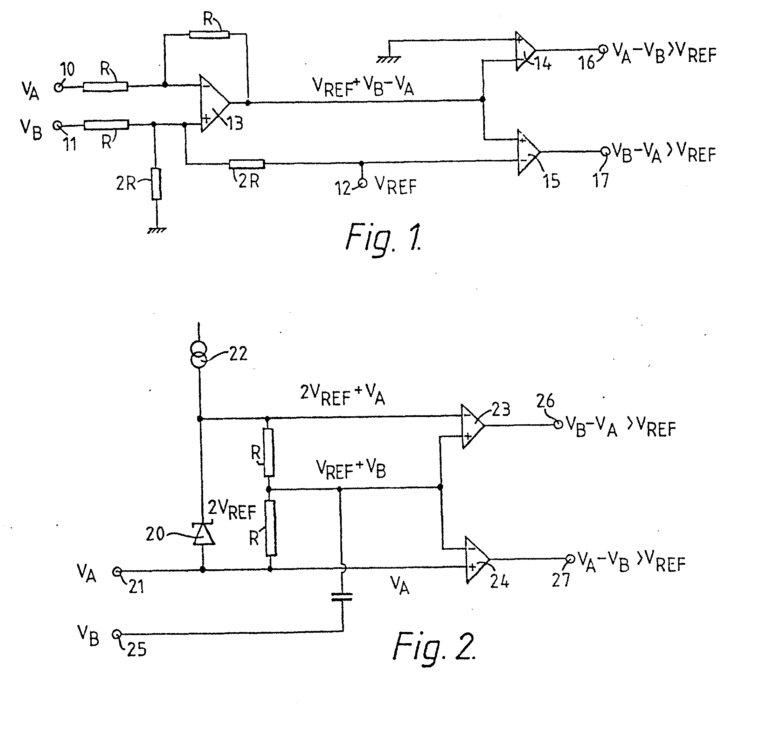

In the circuit of Figure 1 the two input voltages $V_A$ and $V_B$ that are to be compared to see if their voltages difference exceed a certain value $V_{REF}$ are applied to terminals 10 and 11, while a voltage of $2V_{REF}$ is applied to terminal 12. The relative magnitudes of the resistors around operational amplifier 13 can be seen to ensure that its output sits at $V_{REF}$ + $V_B$ - $V_A$. This feeds two further operational amplifiers 14 and 15 which can be seen to turn on providing outputs at 16 and 17 respectively when $V_A$ - $V_B$ > $V_{REF}$ and when $V_B$ - $V_A$ > $V_{REF}$. The principle disadvantages of this approach are the relatively large number of transistors employed and the relative slowness of its operation.

The circuit of Figure 2 uses one less operational amplifier, and achieves level shifting by means of a reference diode 20 providing a voltage offset of $2V_{REF}$. In this circuit $V_A$, which is applied to input terminal 21, is voltage shifted by the combination of the reference diode 20 and a constant current source 22 before being applied to the inverting input of operational amplifier 23. The unshifted voltage $V_A$ is also applied direct to the non-inverting input of operational amplifier 24. The voltage $V_B$, which is applied to input terminal 25, is capacitatively coupled to the other inputs of the operational amplifiers while the two resistors R form a potential divider providing a mean voltage offset of $V_{REF}$. Thus operational amplifier 23 is turned on to provide an output at output terminal 26 whenever $V_B$ - $V_A$ > $V_{REF}$. Similarly operational amplifier 24 is turned on to provide an output at output terminal 27 whenever $V_A$ - $V_B$ > $V_{REF}$.

Although the circuit of Figure 2 uses one fewer operational amplifiers than that of Figure 1, it suffers from the disadvantage that the particular manner of obtaining a voltage offset of $V_{REF}$ from an offset of

$2V_{REF}$ means that the circuit will only handle alternating voltages. This restriction can be avoided by deriving the requisite $V_{REF}$ offset in the same manner as the deriving of the $2V_{REF}$ offset, but this means that the circuit requires two separate voltage offsets, one of which is exactly twice that of the other. This presents problems, particularly if it is desired to be able to adjust the magnitude of the voltage offset, for instance by replacing the reference diode with a resistor.

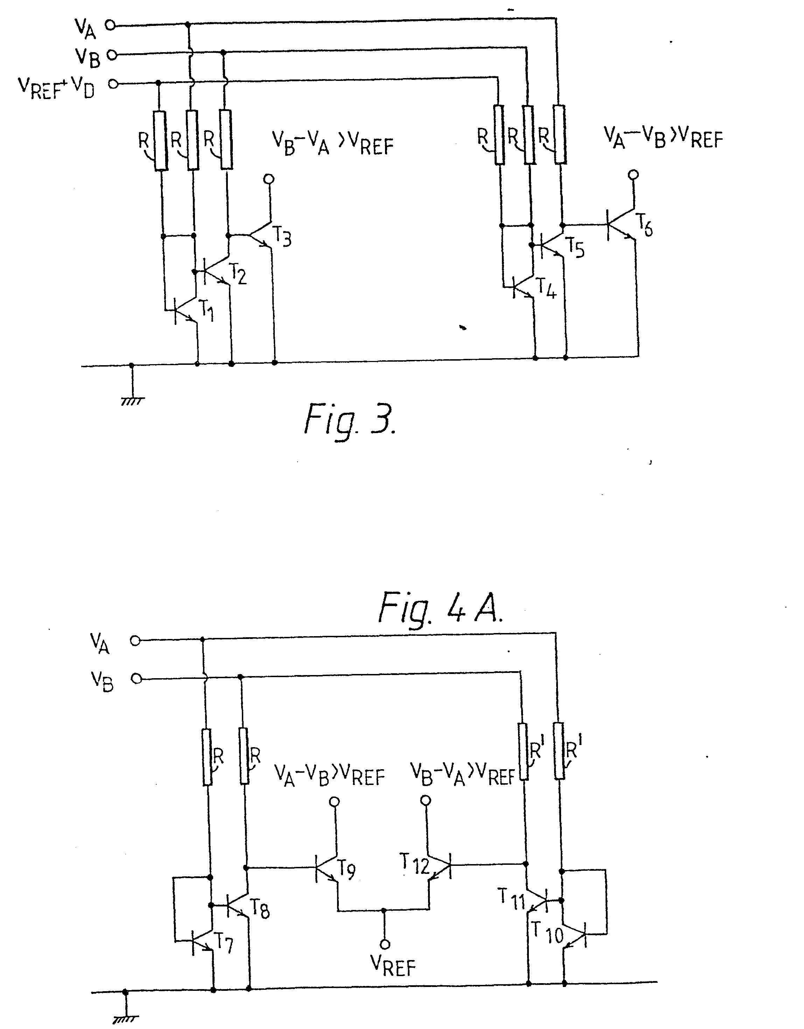

The circuit of Figure 3 employs fewer transistors than either of the circuits of Figures 1 and 2. Unlike the circuit of Figure 2 it is able to operate both a.c. and d.c. with only the one voltage offset. Transistors $T_1$ and $T_2$ of a first amplifier circuit are connected in current mirror configuration, and also transistors $T_4$ and $T_5$ of a second amplifier circuit. With all resistors of equal value R, and with matched transistors, the voltage appearing at the base of $T_3$ is $V_B - V_A - (V_{REF} + V_D)$, while that at the base of $T_6$ is $V_A - V_B - (V_{REF} + V_D)$. Therefore, if $V_D$ is equal to the base emitter voltage of transistors $T_3$ and $T_6$, then $T_3$ is on whenever $V_B - V_A$ $V_{REF}$ and similarly $T_6$ is on whenever $V_A - V_B$ $V_{REF}$.

The basic disadvantage of the circuit of Figure 3 is that the voltage that has to be input to the circuit for an offset voltage of $V_{REF}$ is not $V_{REF}$, but $V_{REF} + V_D$, and hence a supply of $V_{REF}$ requires level shifting before it can be used in this circuit.

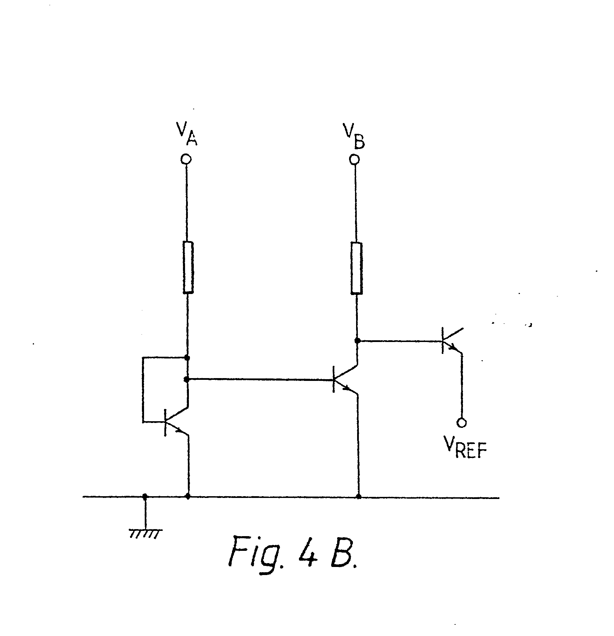

The circuit of Figure 4 also uses a pair of current mirrors, these being formed respectively by transistors $T_7$ and $T_8$, and by transistors $T_{10}$ and $T_{11}$. Both resistors R of the first current mirror must be of equal value, similarly both resistors R' of the second current mirror must be of equal value. On the other hand, although it is generally preferred to choose the value of R' to be equal to that of R, this is not essential for the satisfactory operation of the difference detector. The voltage appearing at the base of transistor $T_9$ is $V_D + V_A - V_B$, whereas that appearing at the base of transistor $T_{12}$ is $V_D + V_B - V_A$. Therefore, transistor $T_9$ is on whenever $V_A - V_B > V_{REF}$ while transistor $T_{12}$ is on whenever $V_B - V_A > V_{REF}$.

For some applications there is a need to monitor only one of the two inequality relationships in which case half the circuit of Figure 4A can be dispensed with to provide the circuit of Figure 4B.

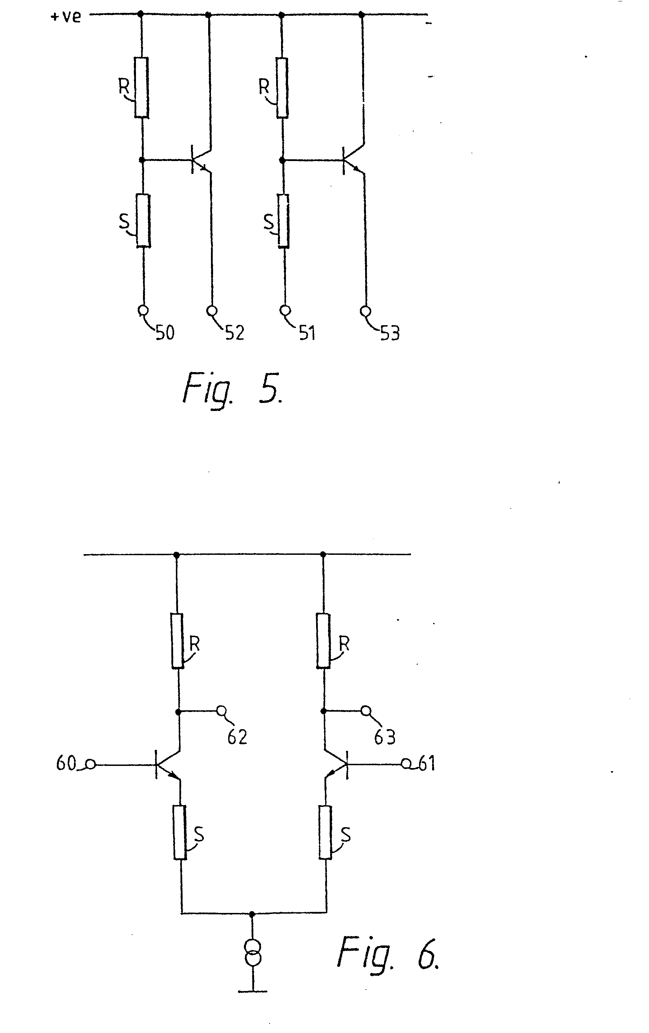

Typically, the voltage to be compared will not be applied directly to the input terminals 40, 41 of the circuit of Figure 4A or 4B, but will first be level shifted and buffered. One piece of circuitry for this purpose is illustrated in Figure 5. Here $V_A$ and $V_B$ are respectively applied to input terminals 50 and 51, while the output terminals 52 and 53 are respectively connected to terminals 40 and 41 of the circuit of Figure 4A or 4B. Typically, though not essentially, resistors R have the same resistance value as that of resistors S.

An alternative to the level shifting and buffering circuit of Figure 5 is provided by the circuit of Figure 6 which has input terminals 60 and 61 and output terminals 62 and 63 for connection to terminals 40 and 41 of Figure 4A or 4B.

CLAIMS :

1. A voltage difference detector having first and second signal voltage inputs connected by_matching resistors to the collectors of two grounded emitter transistors of a current mirror constructed such that in operation the current in the collector circuit of the first transistor is matched by that of the second, characterised in that the collector of the second transistor is strapped to the base of a matching third transistor whose emitter provides a reference voltage input.

2. A voltage difference detector including a pair of current mirrors constructed such that in operation the collector current of a first transistor of each current mirror is matched by an equal collector current in a second transistor of that current mirror, characterised in that the collectors of the second transistors of the two current mirrors are respectively strapped to the two bases of two level sensing transistors providing a reference voltage input for the difference detector at their commoned emitters, and wherein the collector circuits of the first and second transistors of each current mirror are provided with a matching pair of resistors which are cross coupled with those of the other current mirror so as to provide first and second signal voltage inputs for the difference detector, with the first signal voltage input connected via one of the resistors with the collector of the first transistor of one of the current mirrors and via another of the resistors with the collector of the second transistor of the other of the current mirrors, and with the second signal voltage input connected respectively with the other two collectors of the transistors of the current mirrors via the other two of the resistors.

3. A voltage difference detector including a matched pair of amplifier circuits, wherein each amplifier circuit consists of matched first and second transistors with commoned emitters and matching resistors in their collector circuits that provide first and second inputs of the amplifier circuit, the first transistor being diode connected and having its collector strapped to the base of the second transistor whose collector provides the output of the amplifier circuit characterised in that in said difference detector the outputs of the amplifier circuits are respectively strapped to the bases of two level sensing transistors providing a reference voltage input for the difference detector at their commoned emitters, and wherein the inputs of the amplifier circuits are cross connected to provide a first difference detector input that is connected with the collector circuit of the first transistor of one circuit amplifier and that of the second transistor of the other circuit amplifier and to provide a second difference detector signal voltage input that is connected with the collector circuit of the second transistor of the one circuit amplifier and that of the first transistor of the other circuit amplifier.

4.      A differential line receiver incorporating a voltage difference detector as claimed in claim 1, 2 or 3.

5.      A balanced window detector incorporating a voltage difference detector as claimed in claim 1, 2 or 3.

0176165

$V_A$ 10 R

$V_B$ 11 R'

2R

2R

13

$V_{REF}$ + $V_B$ - $V_A$

14 16 $V_A$ - $V_B$ > $V_{REF}$

12 $V_{REF}$

15 17 $V_B$ - $V_A$ > $V_{REF}$

Fig. 1.

22

$2V_{REF}$ + $V_A$

23 26 $V_B$ - $V_A$ > $V_{REF}$

R

$V_{REF}$ + $V_B$

$2V_{REF}$

20 R

$V_A$ 21 $V_A$ 24 27 $V_A$ - $V_B$ > $V_{REF}$

$V_B$ 25

Fig. 2.

Fig. 3.

Fig. 4 A.

Fig. 4 B.

+ve

R          R

50    52    51    53

Fig. 5.

R          R

62        63

60        61

S          S

Fig. 6.